# EUROPEAN PATENT APPLICATION

(11) **EP 4 187 262 A1**
(43) Date of publication of application: **31.05.2023**
(21) Application number: 21210599.3
(22) Date of filing: 25.11.2021
(51) Int. Cl.: G01R 15/20, G01R 33/00

(54) **STRESS REDUCTION LAYER BASED ON COATING TECHNIQUE**

(71) Applicant: Melexis Technologies SA, 2022 Bevaix (CH)
(72) Inventor: PUT, Brecht, 3980 Tessenderlo (BE); VANGERVEN, Tim, 3980 Tessenderlo (BE)
(74) Representative: DenK iP bv

(57) **Abstract**

The present invention provides a sensor and method for manufacturing the sensor including a first component comprising a first material with a predetermined first value of coefficient of thermal expansion (CTE), a second component over the first component, the second component comprising a second material with a predetermined second value of CTE different from the first value. An interlayer is provided by molecular layer deposition, for minimizing stress caused by coefficient of thermal expansion mismatch between the first and second components. The interlayer includes an organic-inorganic hybrid polymer compound.

## Description

### Field of the invention

The invention relates to the field of microelectronic devices. More specifically it relates to integrated circuits, packaged integrated circuits and manufacture thereof.

### Background of the invention

Manufacture of integrated circuits and packaging thereof involves distributing different materials adjacent to one another, for example providing metallic sheets or layers close to, or in contact with, a semiconductor die, e.g. providing conductive leads, and then overmolding the die and conductive leads with molding material for obtaining a packaged integrated device or packaged chip.

This means that materials with different physical properties are usually in contact, which can result in stresses when the packaged chip is in aggressive environments, for example when subjected to high temperatures and temperature gradients. This may lead to stressed structures, and even buckling or cracking, or delamination, reducing the performance of the device. For example, cracking and delamination may result in worse voltage isolation, and/or signal drift in sensing devices. Exposure to large thermal changes is difficult to avoid by design in case of, for example, sensors, which usually require to be placed in environments where thermal stability is very difficult to control.

Thermal stress in structures such as metal sheets on semiconductors, e.g. in case of Hall effect-based sensors, usually has a negative effect in signal accuracy, which may change during the life time of the sensor (signal drift). Existing technologies include coating PI on top of the stressed structures. The application of PI on top of the device presents attachment issues, which may worsen sensor performance and ultimately lead to signal drift. Alternatively or additionally, stress can be reduced by introducing stress-relieving structures and features on the material. For example, conveniently shaped slots can be provided on these metal sheets or plates, but the complexity level of the manufacturing process increases.

It would be desirable to provide stress relief without the need of carefully shaping the plates and without using PI.

### Summary of the invention

It is an object of embodiments of the present invention to provide a manufacture process of a packaged IC, in particular manufacture of a sensor, and a sensor with high thermal resilience, with reduced thermal stresses and reduced risk of delamination or buckling.

In a first aspect, the present invention provides a method of manufacturing a sensor, the method comprising providing a first component comprising a first material, and providing a second component over the first component, the second component comprising a second material different from the first.

The method comprises further providing an interlayer by molecular layer deposition of a third material, being an organic-inorganic hybrid polymer compound, on the first component, for minimizing stress caused by the difference of materials of the first and second components, for example thermal stress.

It is an advantage of embodiments of the present invention that a buffer layer compensates for stress between two adjacent different materials, reducing for example thermal stress and potential delamination. This facilitates manufacturing steps including high-temperature deposition, such as ALD, for providing the second component, and limits build-up of stresses from other high-temperature processes like molding. In sensing devices, stress reduction provides also signal drift reduction.

For example, the first material may have a predetermined first value of coefficient of thermal expansion (CTE), the material of the second component (provided over the first component) is a second material with a predetermined second value of CTE different from the first value. The hybrid polymer compound buffers differences in thermal expansion between the two components with different CTEs.

In some embodiments of the present invention, providing the first component comprises providing a lead frame. As lead frames include materials with typically large thermal effects (such as metals), it is an advantage of embodiments of the present invention that the relatively large thermal expansion and contraction can be buffered by the conformal interlayer.

In some embodiments of the present invention, providing the first component comprises providing a semiconductor substrate including integrated circuitry. It is an advantage of embodiments of the present invention that the semiconductor substrate or die, comprising the integrated electronics of the device, can be protected from thermal stresses before packaging.

In some embodiments of the present invention, providing a second component comprises forming a metallic layer over the semiconductor substrate. It is an advantage of embodiments of the present invention that attachment of a metallic layer to a die can be improved even in presence of large temperature changes during manufacture and/or during the lifetime of the device.

In particular embodiments, forming a metallic layer comprises forming Hall effect plates or integrated magnetic concentrators.

It is an advantage of embodiments of the present invention that sensors, e.g. magnetic and current sensor, can be provided with good signal drift characteristics.

In some alternative embodiments of the present invention, providing the second component comprises providing a molding material.

It is an advantage of embodiments of the present invention that good adhesion between the die and the protective package mold can be provided. This allows good protection against delamination and good isolation of the die from the environment.

In some embodiments of the present invention, providing an interlayer comprises providing a conformal interlayer. It is an advantage of embodiments of the present invention that the interlayer covers substantially all the surface of the component thanks to the conformality of the interlayer.

In some embodiments of the present invention, providing the interlayer comprises providing alucone. It is an advantage of embodiments of the present invention that alucone can be provided using typical manufacturing techniques with the same setup as ALD. It is a further advantage that alucone has a CTE between a typical metal used in microelectronic device and a semiconductor or compounds used in integrated circuitry, such as silicon and oxides thereof.

In a further aspect, the present invention provides a sensor including a first component comprising a first material, a second material, and an interlayer comprising a third material between the first component and the second component. The third material is an organic-inorganic hybrid polymer compound for minimizing stress caused by mismatch between the first and second components. It is an advantage of embodiments of the present invention that such sensor presents a good performance for most of or all of its lifetime, by reducing thermal stress between different adjacent components. It is an advantage that stress buffering is provided by the hybrid polymer compound. The hybrid polymer compound may have a sponge-like, porous structure, enhancing stress buffering.

As explained earlier, the thermal stresses due to differences in CTE of the first and second materials can be buffered by the presence of the hybrid polymer.

In some embodiments of the present invention, the conformal interlayer comprises alucone. It is an advantage of embodiments of the present invention that such sensor presents an interlayer whose CTE value is between the typical values between a mold and a semiconductor.

In some embodiments of the present invention, the first component comprises a lead frame and the second component comprises molding material. It is an advantage of embodiments of the present invention that such sensor presents high resilience to changes of temperature, thanks to the lower stress between the metal and the mold, which reduces the chance of delamination and package crack.

In some embodiments of the present invention, the first component comprises a semiconductor substrate and the second component comprises molding material. It is an advantage of embodiments of the present invention that the integrated circuit provided in the semiconductor die is protected against compression or tension stress from changes of temperature of the circuit itself or from the mold.

In some embodiments of the present invention, the first component comprises a semiconductor substrate and the second component comprises a metallic layer. It is an advantage of embodiments of the present invention that the intermediate layer ensures good adhesion between the die and any track or plate provided thereon.

In particular, the sensor may be a sensor for sensing magnetic field wherein the second component is a plate for Hall-effect sensing or an integrated magnetic concentrator.

It is an advantage of embodiments of the present invention that a low signal drift can be obtained for most part or all of the lifetime of the sensor.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG 1 is a schematic chart with steps of a method in accordance with embodiments of the present invention, including adding a buffer interlayer to a component.
FIG 2 is a schematic chart with steps of a method in accordance with embodiments of the present invention, including providing electric connections between components before adding a buffer interlayer to the connected components.
FIG 3 shows a sensor in accordance with embodiments of the present invention, where the interlayer is provided between the lead frame pad and the semiconductor die.
FIG 4 shows a sensor in accordance with embodiments of the present invention, where the interlayer is provided on the silicon die, between the semiconductor die and the mold and lead frame pad.
FIG 5 shows a sensor in accordance with embodiments of the present invention, where die and the lead frame pad are assembled and in contact to each other, and the interlayer is provided between both of them and the mold.
FIG 6 shows a sensor in accordance with embodiments of the present invention, where the interlayer is provided between the die and an integrated magnetic concentrator (IMC).
FIG 7 shows a sensor in accordance with embodiments of the present invention, where the interlayer is provided between the IMC and the mold.
FIG 8 shows a sensor in accordance with embodiments of the present invention, where the IMC is embedded within the interlayer, so there is material from the interlayer between the IMC and the die and between the IMC and the mold.
FIG 9 shows a sensor in accordance with embodiments of the present invention, where the mold extends below the leads.
FIG 10 shows a sensor in accordance with embodiments of the present invention, including an insulating layer around the primary LF, where the interlayer is provided between the primary LF and the insulating layer.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings, but the invention is not limited thereto but only by the claims. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some, but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures, and techniques have not been shown in detail in order not to obscure an understanding of this description.

Where in embodiments of the present invention reference is made to "integrated sensor", reference is made to a sensor including a semiconductor (SC) die with integrated circuitry. It usually includes other components, depending on the type of circuit and sensor. These other components may include primary lead frames for probing currents, metallic plates for sensing and/or concentrating magnetic fields, secondary lead frames for redirecting measurement signals, a mold formed by a compound such as epoxy or the like, for protecting the delicate components, etc.

Where in embodiments of the present invention reference is made to "conformal layer" reference is made to a layer that follows the shape and topography of the overlying substrate. A non-conformal coating layer on a flat substrate usually presents the layer on the large areas of the main surfaces, and the surfaces in the thickness direction (the faces of the substrate with smaller areas, such as the edges of the flat substrate) may present traces of the coating layer, with irregular coating. By contrast, a conformal layer can envelop a flat substrate, where a plurality of surfaces of the substrate or even each surface of the substrate can be coated by substantially the same thickness of material. For example the layer may be present on a main surface and one or more side surfaces, optionally also covering partially or totally the surface of the opposite side of the main surface. The layers have substantially the same thickness. In particular, a conformal layer may be defined by the depth of coating within a trench or gap relative to the gap width.

Conformal layers are obtained by layer deposition. Layer deposition which include self-limiting techniques that are able to cover completely inner surfaces of trenches or gaps (instead of clogging them near the top, as usually happens with CVD). Layer deposition also can provide homogeneous thickness within inner surfaces of gaps, and in more than one side (e.g. a main side and lateral sides, optionally also opposite side of the main side) of overhanging structures, while for example sputtering only provides material on the surface facing the sputtering target. Conformal layers can wrap several surfaces of a substrate or the whole substrate completely. In particular, a ratio can be defined relative to a conformal layer, by the depth of coating within a trench or gap relative to the gap width.

A typical problem faced in microelectronics, particularly in sensors, is thermal stress due to exposure to temperatures changes, if the device is in presence of thermal sources or sinks, and/or extreme temperatures. These changes cause volume changes in the elements of the device. Sensors are highly compact and include many different materials which change their volume to a different degree. These materials form parts or components of the device which are adjacent to each other, for example in physical contact with each other.

More in detail, different materials usually have different properties, in particular different coefficients of thermal expansion (CTE). Upon changing the temperature, the volume of materials usually changes. When two components made with materials with a different CTE are in physical contact (e.g. SC die and mold compound, oxide and lead frame...), these volume changes are different between the two components. Mismatch in coefficient of thermal expansion (CTE) between different sensor components generate stresses, which may happen during the lifetime of the device.

In case of sensors, stress of sensor components worsens signal drift specifications. In some cases, depending on the temperature changes and the materials involved, stress may be so large that it leads to buckling or cracking, or delamination between the components. These phenomena are detrimental for the performance of the device. For example, they can generate cracks on chemical barriers and on voltage isolation barriers. These issues may reduce device performance, its lifetime, etc.

The present invention includes providing a flexible coating on at least one component, using molecular layer deposition (MLD). MLD is a modified version of the classic microelectronics processing technique known as atomic layer deposition (ALD). The coating or interlayer alleviates the stress between neighbouring materials. Despite the low thickness of the coating relative to the components sandwiching it, the effect of material mismatch can be reduced during manufacture and lifetime of the device. For example, the CTE difference between the sensor components can be properly buffered and its disadvantageous effects (such as thermal stress) can be reduced or even avoided.

Existing solutions such as applying a PI film result in thick PI coatings, of tens or even hundreds of microns and which may result in attachment issues as explained in the background section. The present invention provides very thin flexible, which may reach few microns, and still provide long term attachment.

These flexible coatings may comprise organic-inorganic hybrid polymer, for instance material from the so-called metalcones, which include layers of metallic atoms interlayered with carbon. Such polymers have inorganic material linked by carbon chains. Stresses and cracking, due to the different materials used in the first and second components, are reduced due to the elastic properties of these materials. They are usually provided by molecular layer deposition (MLD) which is a modified ALD technique. The unique nature of the MLD technique additionally allows conformal coating (similar to ALD), and can typically be done in the same equipment as ALD. Thus, MLD can be carried out within the manufacturing flow of the microelectronic sensor, similarly to ALD, which reduces manufacturing time and chances of contamination.

In some embodiments of the present invention, a combination of several layers can be provided. For example, a hybrid polymer layer can be combined with an atomic layer provided by ALD. This can be provided to improve attachment between the different components and the hybrid polymer layer. For example, the flexible coating may be deposited by MLD, and then sealed by deposition of an additional layer provided by ALD, for example a metallic layer. This may improve flexible layer protection, for example against high temperatures. In some embodiments, the flexible layer may be sandwiched between two layers provided by ALD.

In a first aspect, the present invention relates to a method of manufacture of microelectronic sensors including integrated circuits. The method comprises providing a first component (semiconductor die, a metallic substrate such as a lead frame, for example) and providing an interlayer comprising organic-inorganic hybrid polymer, by MLD. The method comprises providing a second component over the first component and the interlayer. The second component may be for example a metal plate or mold.

In other words, the method comprises providing an organic-inorganic hybrid polymer by MLD between at least a first component and at least a second component of a sensor, so there is no direct contact between these at least some of the interfaces between these components, the polymer being sandwiched between the two components. The components are different pieces and comprise different materials, which are assembled or packaged to provide a sensor. These components include but are not limited to one or more semiconductor dies for the integrated circuitry, one or more lead frames and/or frame pads, and mold.

In some embodiments, providing the interlayer may comprise providing hybrid polymer of few nanometers, e.g. 10 nm, up to 2 microns or more, for example 2.5 microns, for example the interlayer may have a thickness of 500 nm.

The interlayer may be provided over more than one component. For example, the interlayer may be provided over two assembled components such as an SC die and a Hall sensor, or an LF frame and an SC die. Subsequently, a further component may be provided, for example the assembled and coated components may be overmolded.

The flexible interlayer reduces stresses due to exposure of temperature changes during the life time of the sensor. The interlayer also reduces stress during manufacture of the sensor. For example, some deposition techniques and/or molding require high temperatures and subsequent cooling, which may also generate stresses. These can be reduced by the provision of a flexible interlayer in accordance with embodiments of the present invention before said treatment (e.g. said deposition).

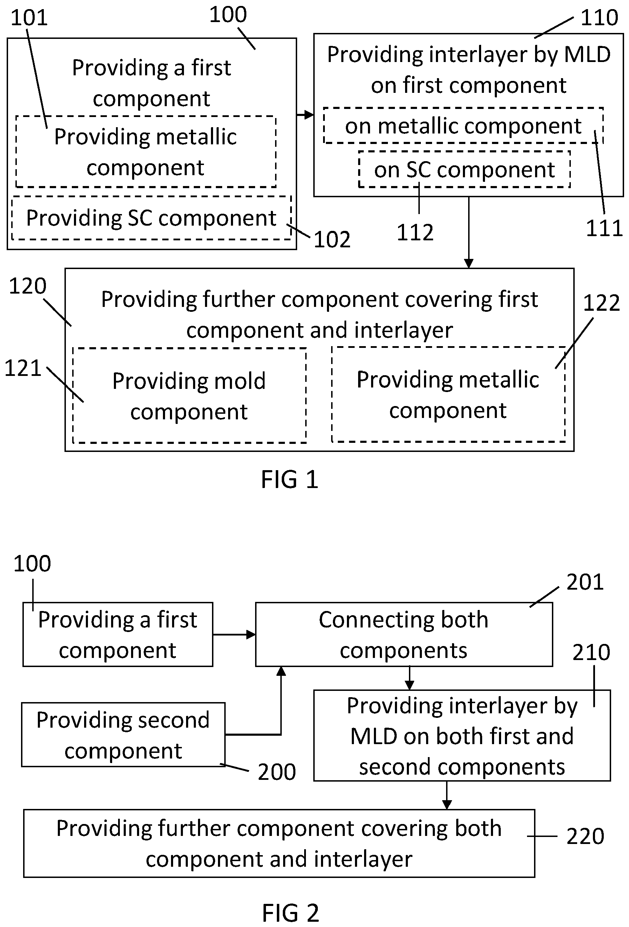

FIG 1 shows schematically an exemplary embodiment of the method. The method comprises the steps of providing 100 at least one first component of a microelectronic sensor. In some embodiments, it may include providing 101 a metallic component such as a metal plate for sensing or the like, or a lead frame (LF), for example a primary lead frame, a LF pad, etc. In some embodiments, it may include providing 102 a semiconducting component such as an SC die, for example a die where the circuit is monolithically integrated.

The method comprises depositing 110 an interlayer of a further material on the first component. In particular, the method comprises providing organic-inorganic hybrid polymer compound by molecular layer deposition, forming an interlayer. In some embodiments, this comprises depositing 111 by MLD the organic-inorganic hybrid polymer compound on the metallic component, e.g. on the LF such as the LF pad, on metal plates, etc. For example, the interlayer may be provided 112 on the SC component, e.g. on the SC die.

The method may comprise providing a metalcone, for example comprising alucone. Other hybrid polymers can be used, e.g. including transition metals, e.g. zirconium-based hybrid polymer (zircone). As MLD is similar to ALD, there is no need to set up and optimize from the scratch special manufacturing routes since layer deposition is a well-known technique.

Subsequently, the method comprises providing 120 a second component over the first component, such that the second component covers at least a portion of the first component, while covering additionally the interlayer, so at least a portion of the first and second components sandwich the interlayer, optionally where the interlayer is present in the whole interface between the first and second components so there is no physical contact between these first and second components.

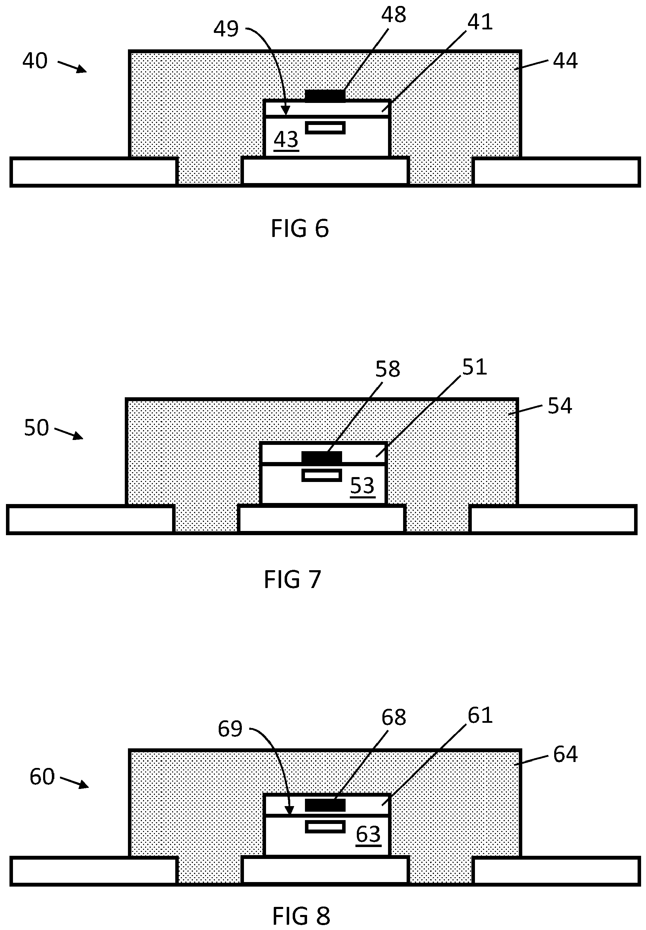

The second component includes a material which is different from the first material. In particular the material of the first component has a first predetermined value of CTE and the material of the second component has a second value of CTE different from the first value. In some preferred embodiments, the second component is disposed so that the interlayer separates both components and there is no direct contact between the material of the first component and the material of the second component. This allows good buffering between both, reducing the chances of delamination. However, the present invention is not limited thereto, and a small percentage of the contact area between both components may be in direct contact. For example, in FIG 7 shows complete separation between the mold 54 and the IMC 58 and only partial separation between the mold 54 and the SC die 53, as it will be explained below.

In some embodiments, providing the second component comprises providing 121 mold component, for example by overmolding with mold compound (based on epoxy or in general based on resin or polymer, etc.) the first component and the interlayer on top thereof, for example overmolding the SC die, or by overmolding the lead frame.

In some embodiments, the interlayer is sandwiched between the SC die and the mold, or between the lead frame and the mold, so it can buffer volume changes between components which usually present very large difference of CTE in presence of heat, e.g. environment heat.

In some embodiments, providing the second component comprises providing 122 a metallic plate, for example a sensing element such as a Hall element or the like, for example a magnetic concentrator, e.g. an integrated magnetic concentrator (IMC). The interlayer is sandwiched between the metallic plate and the semiconductor, for example. Differences of volumetric change between the semiconductor of the die and the metal of the plate, upon change of temperature, are advantageously buffered by the interlayer. Delamination of metal components, e.g. IMC delamination, can be reduced in this way.

In general, thermal stresses can be reduced by the presence of the buffer layer as the buffer layer has elastic properties. These thermal stresses are originated by the differences of CTE of the materials of the different components. As explained earlier, CTE of materials suitable for microelectronic devices usually differ so much that stresses may cause signal drift in sensor and even delamination.

For example, the CTE of metals for microelectronics is usually higher than 9 x 10⁻⁶/K, e.g. between 11 x 10⁻⁶/K and 20 x 10⁻⁶/K . For instance, the CTE of copper (e.g. C151) is 17.7 x 10⁻⁶/K in the range between 293 K and 573 K. On the other hand, the CTE of semiconductors such as the widely used silicon is around 2.6 x 10⁻⁶/K, whereas mold compound usually has a CTE value of 20-21 x 10⁻⁶/K, depending on the composition of the mold. The interlayer is provided so that stress due to different volume changes of the components to temperature changes, due to the relatively large difference of CTE values, can be buffered, thanks to the elastic properties of the organic-inorganic hybrid polymer of the interlayer.

In some embodiments, the method may comprise depositing by MLD an interlayer comprising organic-inorganic hybrid polymer with a coefficient of CTE value between the CTE value of the materials of the first and further components respectively. Since the interlayer has a CTE value between the values of the two components in contact with the interlayer, volume changes of the interlayer will be intermediate between the volume changes of the adjacent components, further reducing the stress between them, improving protection against stress due to changes of temperature, together with the elastic properties of the interlayer.

In some embodiments the method includes depositing an interlayer comprising aluminium, e.g. depositing alucone by MLD. Alucone has a CTE of 12 x 10⁻⁶/K and is therefore a good buffer layer which further reduces or even prevents stress build up between a metal (CTE of approximately 17 x 10⁻⁶/K) and an oxide or semiconductor (CTE between 2-9 x 10⁻⁶/K), and also between a SC such as silicon (CTE of 2.6 x 10⁻⁶/K) and mold compound (which usually have a CTE over alucone, as shown earlier).

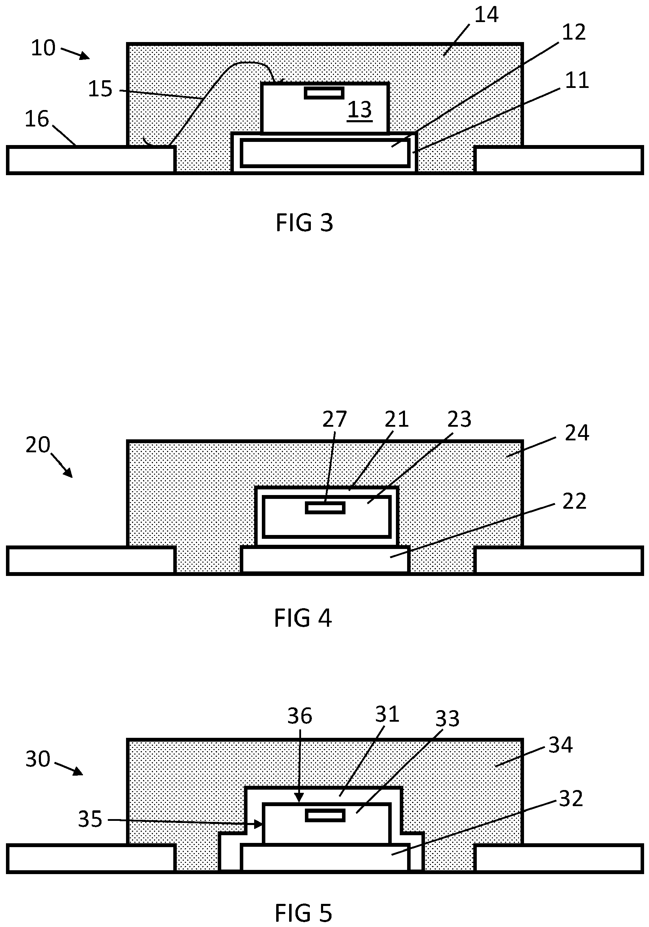

In some embodiments, the method may comprise providing the interlayer so it separates a plurality of components from another component. This will be shown in FIG 4 to FIG 9 below.

For example, the method may comprise providing a first substrate (such as an SC die), covering it by MLD with a hybrid polymer, subsequently providing a second component (such as a plate, e.g. an IMC) on the first component and on the interlayer, e.g. partially overlapping these so that the IMC does not contact the SC die, while leaving part of the interlayer not overlapped. Afterwards, a third substrate can be provided.

Alternatively, the method may comprise covering two components by an interlayer and providing a further (third) sensor component. FIG 2 shows schematically a method in accordance with embodiments of the present invention, including providing 100 a first component as before, providing 200 a second component and connecting 201 both components, for example electrically connecting them. The method includes providing 210 interlayer on both components, by MLD. Afterwards, a further component is provided 220 covering both covered components and the interlayer.

In some embodiments, providing 110, 210 the interlayer includes providing an interlayer stack, including providing an organic-inorganic hybrid polymer layer by MLD and a further layer by ALD. This can be done to enhance adhesion to one of the components. For example a metallic layer or an insulating layer, such as an oxide, can be provided. In some embodiments, the additional layer by ALD may seal the hybrid polymer. An interlayer with a hybrid polymer and an additional layer provided by ALD has improved temperature stability, which can be useful to improve adhesion to materials provided at high temperature processes (e.g. improve adhesion to mold compound) and which may reduce influence of the temperature on the performance of the device during its lifetime (for example, it may further reduce signal drift in case of sensors).

In some embodiments where the first substrate is a SC die, the second substrate is an IMC and the third substrate is a mold, the interlayer may be provided on top of an SC die with an IMC provided on the same surface, before molding, thus providing a packaged sensor. The sensor shown in FIG 7 can be obtained in this way.

For example, a metallic LF pad and an SC die may be assembled and covered by hybrid polymer, by MLD, before molding, so the interlayer is interposed between the mold and the assembled the metallic components and SC components, thus providing a packaged sensor. The sensor shown in FIG 5 can be obtained in this way, showing that the layer may be provided on the areas which would otherwise contact with the mold, whereas the bottom surface of the LF pad 32 is not covered by the interlayer 31 (e.g. hybrid polymer), since the mold does not extend below the lead frames.

In some embodiments, the interlayer can be provided on at least one component after electrical connections are manufactured on that component. These connections may be provided by different techniques, such as wire bonding or flip-chip bonding. In these cases, outer leads or a portion thereof can be protected, e.g. by a mask, by selective coating, by applying a tape on the areas to be left free of interlayer, etc.

The electrical connections could be provided after providing the interlayer. For example, predetermined zones of a lead frame may be shielded during layer deposition, to prevent them from being covered by the polymer, said zones being zones for contacting e.g. a line for probing an electric current. For example a surface of the die including contact zones may be shielded before deposition on the die. It is an advantage that the interlayer may be temperature stable, so the interlayer can withstand reflow temperatures or annealing process (such as magnetic anneals of IMCs, at around 300 degrees). This temperature stability may be further improved by providing a hybrid layer including coating provided by MLD and sealed by ALD, as explained earlier.

In some embodiments, the interlayer and the components can be provided so that the interlayer separates a first component from more than one further component, e.g. from a second and from a third components. For example, a first substrate may be covered by an interlayer, where a second substrate is provided. Subsequently the second substrate is also covered by MLD with hybrid polymer, and a third substrate is provided by covering the substrates and layer. In some embodiments where the first substrate is a SC die, the second substrate is an IMC and the third substrate is a mold, the IMC can be embedded within the interlayer before molding, so there is hybrid polymer at least between the SC die and the IMC and between the IMC and the mold compound. The sensor shown in FIG 8 can be obtained in this way.

In some embodiments, the method comprises providing a conformal interlayer. A conformal interlayer presents a very homogeneous thickness and ensures that gaps and topology irregularities can be covered by the hybrid polymer. This allows better buffering against thermal stress, and better protection against cracking, delamination or the like. The MLD can be performed so the resulting interlayer has a conformality of 100 or more (so the inner surfaces of a gap will be covered with a depth at least 100 times larger than the gap width).

FIG 6 to FIG 8 shows examples of sensors where an interlayer is completely interposed between two substrates, e.g. between the IMC and the SC die and/or between the IMC and the mold. However, the interlayer does not cover completely the first substrate. In these particular embodiments, there is direct contact between the SC die and the mold. However, there is interlayer between the main surface of the SC die and the mold, so there is advantageously stress relief between the mold and the SC die on the main surface of the SC die.

In embodiments of the present invention, the method may comprise providing an electrically insulating layer as a further component. The insulating layer may comprise a metal oxide. The present method includes providing the hybrid polymer between a first component and the insulating layer. The insulating layer may have a thickness similar to the thickness of the interlayer. Thermal stresses between the first component and the insulating layer may be reduced. The insulating layer may comprise, for example, alumina. The method may comprise providing a further component, e.g. a mold and/or a component to be electrically insulated by the electrically insulating layer.

In some embodiments, alucone is provided. As discussed, alucone shows a CTE of around 12 x 10-6/K. The CTE of insulators is usually lower, e.g. the CTE of Al2O3 is 5 x 10-6/K to 9 x 10-6/K . This, combined with its elastic properties, makes it very suitable for buffer the CTE differences between metals typically used as lead frames, and effective insulators such as metal oxides, in particular alumina. For example, alucone may be provided between the primary lead and an alumina insulating layer.

The present method provides sensors with an interlayer with a polymeric material which has spring-like properties. Due to its flexible nature, the interlayer prevents the transmission of stress between adjacent layers. The interlayer may comprise a porous material (sponge-like) which further improves stress buffering. For example, the interlayer provides stress reduction for dual Hall plate measurements and for IMC plates and surfaces, e.g. between the plate and the semiconductor and/or between the plate and the mold, as well as stress reduction between the IC die and mold and between the lead frames and the mold.

In a second aspect, the present invention provides a sensor including an interlayer comprising organic-inorganic hybrid polymer between two components of the sensor. The sensor may be a microelectronic sensor, e.g. an integrated sensor, for example a packaged sensor including a monolithically integrated circuit on a die, or IC die, required electric connections to the exterior, e.g. for rerouting measurement signals, and/or for probing electric signals such as currents to be measured. These connections may comprise lead frames.

The elasticity of the hybrid polymer buffers thermal stresses caused by the differences of CTE value of the materials forming adjacent components in the microelectronics sensor.

This interlayer does not need to negatively affect the compactness of the sensor. MLD can provide the hybrid polymer in layers of hundreds of nanometers up to few microns, e.g. layers of 4 microns or below, for example 2.5 microns or 2 microns or below, e.g. 500 nm. Prior art solutions using polymeric coatings, or the like, usually provide layers with a thickness of tens of microns or more.

In some embodiments, the thickness of the interlayer is at least 100 times lower than the thickness of the material of at least one component surrounding the material, following the same direction as the interlayer thickness. For example, the interlayer is at least 100 times thinner than the mold, measured from the interlayer. For example, the interlayer is at least 100 times thinner than the SC die over which the interlayer may be provided. In some embodiments, the interlayer is 100 times thinner, or even 1000 times thinner, than the components sandwiching it, for example thinner than the mold and thinner than the SC die sandwiching the interlayer.

FIG 3 shows a first embodiment of a sensor 10 where a conformal layer of hybrid polymer 11 is present at the interfaces between a first component 12 (the metallic LF pad) and two other components, namely the semiconductor die 13 and the mold 14. The interface between the LF pad 12 and the SC die 13 is buffered by the interlayer, as well as the interface between the LF pad 12 and the mold 14. This can be provided by methods of the first aspect, where the first component is a lead frame pad, and the second component is a semiconductor. The interlayer 11 is also present between the first component and a further component, i.e. the mold 14. The sensor 10 of FIG 3 also shows an electric connection 15, by wire, between the SC die 13 and an output LF 16. If required, the output LF 16 can be protected to avoid deposition of polymer thereon.

FIG 4 shows an alternative embodiment of a sensor 20 where the SC die 23 (including the sensing element 27) is conformally covered by the interlayer 21. Such interlayer can buffer differences of CTE between the material of the SC die 23 and the LF pad 22 and between the SC die 23 and the mold 24. This is obtained by providing the first component (the SC die 23) and covering by MLD conformally with the hybrid polymer, in accordance with embodiments of the first aspect of the present invention.

It is noted that, usually, semiconductors have lower CTE value than either the mold or typical metals used in LF pads. In some embodiments, the CTE value of the interlayer is chosen so that it falls between the value of the semiconductor and the values of the metal of the LF pad and of the mold. Thus, stresses of the SC die 13, 23 in FIG 3 and FIG 4 with surrounding components are synergistically reduced if the (elastic) intermediate layer has an appropriate CTE value.

In particular embodiments the interlayer comprises alucone. The value of CTE of alucone is intermediate to the values of CTE of semiconducting material in the die 23 (e.g. in case of silicon, but not limited thereto) and the value of the LF pad (e.g. in case of Cu, not being limited thereto). Simultaneously, the value of CTE of alucone falls within the difference of CTE values between the SC die 23 and a typical material for the mold 24.

FIG 5 shows an alternative embodiment where the sensor 30 includes an SC die 33 assembled to a LF pad 32, and an interlayer 31 covers both. Part of the interlayer 31 is sandwiched between the SC die 33 and the mold 34 and part between the LF pad 32 and the mold 34. The SC die and LF pad may be in contact to each other. The SC die and the LF pad may also be in electric contact, if required. Where the interlayer 31 is conformal, any remaining gap between the SC die 33 and the LF pad 32 may comprise also hybrid polymer. The CTE value of the interlayer 31 may also fall between the CTE values of the material of the SC die 33 and the mold 34 and of the metal of the LF pad and the mold 34; for example the interlayer 31 may comprise alucone.

In some embodiments of the present invention, the interlayer 31 covers more than one surface, for example at least two non-coplanar surfaces of a substrate, for example at least two non-coplanar adjacent surfaces, e.g. at least two perpendicular surfaces 35, 36 of the die 33 (or of more than substrate). This is shown in FIG 5, but it may apply to any other component of the sensor. Since the interlayer 'turns edges' of the substrate, it at least partially wraps the substrate, thus improving stress relief.

In the following, FIG 6 to FIG 8 show embodiments of a sensor comprising a plate, for example an IMC, over the SC die comprising the sensing element. The IMC may be disposed relative to the sensing element to allow and/or improve detection, e.g. magnetic field detection. In these embodiments, the interlayer is provided on one of the surfaces of the SC die. The polymer is provided by MLD so the thickness may be very homogeneous, with differences between nominal thickness and actual thickness reaching few nanometers. The interlayer 41, 51, 61 does not need to cover completely the die 43, 53, 63, for example it may only cover top surface of the die.

FIG 6 shows an embodiment where the sensor 40 comprises an interlayer 41 disposed so as to improve thermal resilience between the SC die 43 and the IMC 48. The interlayer 41 may be provided, in accordance with embodiments of the first aspect, over the SC die 43, before providing on top the IMC 48 and subsequently the mold 44. Thus, the behavior of the interlayer is similar to a traditional polyimide layer on the SC die, although the interlayer 41 of embodiments of the present invention may be thinner. Stresses between the main surface 49 of the SC die (where the IMC 48 is disposed) and the mold 44 are also reduced.

FIG 7 shows and alternative embodiment of a sensor 50 where the IMC 58 is disposed in direct contact with the SC die 53, and the hybrid polymer is provided on top of the SC die 53 and the IMC 58, before providing the mold 54. Thus, the interlayer 51 reduces the risk of delamination between the mold 54 and one of the surfaces of the SC die 53, as before, and between the mold 54 and the IMC 58. It is an advantage that the interlayer 51 not only buffers the different thermally driven volumetric changes due to differences of CTE between the IMC 58 and the mold 54, but also the thermally driven volumetric changes due to differences of CTE between the SC die 53 and the mold 54.

FIG 8 shows an alternative embodiment of a sensor 60 where the IMC 68 is embedded inside the interlayer 61 over the SC die 63, so there is hybrid polymer between the SC die 63 and IMC 68 and between the IMC 68 and the mold 64. As explained with reference to embodiments of the method of the first aspect, the hybrid polymer is provided on top of the SC die 63, then the IMC 68 is disposed on the hybrid polymer, and then more hybrid polymer is disposed on the IMC 68, completely covering the IMC 68 and embedding it, before providing the mold 64. For example, the hybrid polymer may be provided conformally over the IMC so the interlayer 61 embeds the IMC 68. The interlayer is disposed so that the risk of delamination between the SC die 63 and the IMC 68, and between the IMC 68 and the mold 64, are all reduced, as the polymer compensates differences in volumetric changes due to thermal changes, by deformation of the polymer, thanks to the elastic properties thereof. As with the previous embodiments of FIG 6 and FIG 7, there is polymer also between the top surface 69 of the SC die 63 and the mold 64, so the stress between the mold 64 and at least the top surface 69 of the SC die 63 will also be reduced.

The previous embodiments in FIG 6 to FIG 8 show sensors where the mold does not extend beneath the leads. The LF pad may be partially embedded only. The present invention is not limited thereto, and the mold may extend below. For example the LF pad may be completely embedded in the mold.

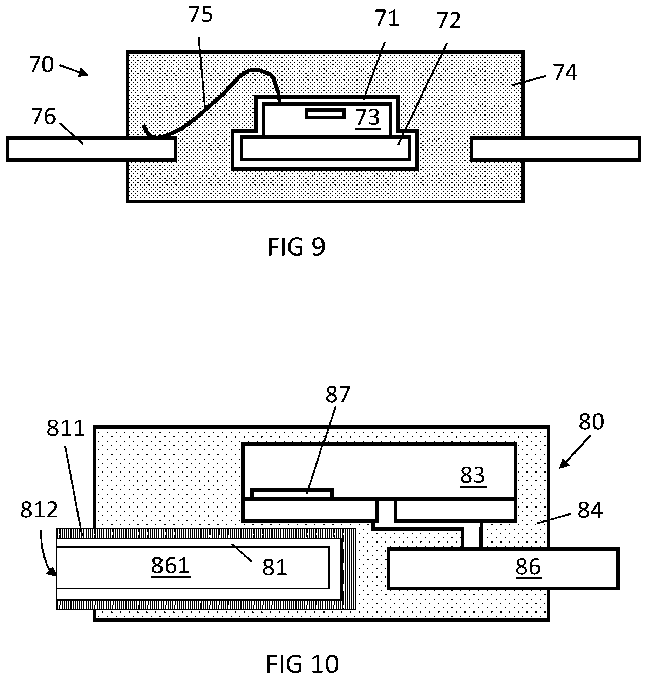

FIG 9 shows such embodiment of a sensor 70. The LF pad 72 and the SC die 73 are joined and both are covered by a conformal interlayer 71. Although the LF pad 72 and SC die 73 are in contact with each other, they are separated from the surrounding mold 74 by the interlayer 71. FIG 9 also shows connections between the IC die 73 and the other lead frames 76, for example by wiring 75, although other possibilities are available, such as e.g. flip-chip bonding.

In preferred embodiments, the hybrid polymer is provided after any electric connections (wires 75, studs, bumps) are manufactured. These wires, bumps or the like may also be covered by polymer, but this does not disturb the conductivity of the connection. In such cases, the outer leads 76 should be protected by covering the region from the polymer, so there is no polymer material in the regions to be connected to an external device or electric line.

FIG 10 shows an example of a flip-chip current sensor 80. The sensor shows a magnetic sensing element 87 provided on an SC die 83. A current can be probed and introduced in the sensor 80 via the primary LF 861. The primary LF 861 may comprise a loop which generates a magnetic field proportional to the probed current. The magnetic flux of the field can be sensed by the sensing element 87, and the integrated circuit of the SC die 83 may provide measurement signals, which can be sent to the output via a secondary LF 86 connected to the SC die 83 by flip-chip bonding.

The primary LF 861 may be partially covered by an insulating layer 811 for electrically protecting the SC die 83, between the primary LF 861 and the mold 84. The insulating layer 811 may be a metal oxide, e.g. alumina, including few monolayers (e.g. provided by ALD). In order to reduce thermal stresses between the primary LF 861 and the insulating layer 811, an interlayer 81 can be included between the primary LF 861 and its insulating layer 811. The distal part 812 of the primary LF 861 is uncovered, so it can be connected to a line for probing current, as explained earlier (e.g. by masking or selective deposition). The interlayer 81 may be provided in accordance with embodiments of the present invention where the first component is the primary LF 861 and the further component the insulating layer 811. The insulating layer 811 and the interlayer 81 may have similar thickness. In some embodiments, the interlayer may be 100 times thinner than the primary LF, for example, a LF with thickness of 250 microns may be combined with an interlayer with thickness of 2.5 microns (e.g. alucone).

The present invention provides sensors with low lifetime drift. During the useful life of a sensor, usually it is exposed to changes of temperature, and in some cases to extreme temperatures. This usually leads to thermal stresses, due to small volumetric changes of the components, which are made of different materials, hence show different volumetric changes also, and may affect the measured signal. For example, compression of conductors or the IC of a semiconductor may cause a signal drift. Thanks to the presence of the buffer interlayer, these stresses are absorbed and compensated because of the elastic nature of the interlayer. As the components suffer less thermal stress, the signal drifts less, or even does not drift. As the stresses may cause delamination and cracks, these detrimental effects are also greatly reduced or avoided.

These effects are noticeable even with a low thickness of interlayer relative to the thickness of components surrounding the interlayer.

## Claims

1. A method of manufacturing a sensor, the method comprising
- providing a first component comprising a first material,
- providing a second component over the first component, the second component comprising a second material different from the first, and
- providing an interlayer by molecular layer deposition of a third material being an organic-inorganic hybrid polymer compound on the first component, for minimizing stress caused by mismatch between the first and second components.

2. The method of the previous claim wherein providing the first component comprises providing a lead frame.

3. The method of claim 1 wherein providing the first component comprises providing a semiconductor substrate including integrated circuitry.

4. The method of the previous claim wherein providing a second component comprises forming a metallic layer over the semiconductor substrate.

5. The method of the previous claim wherein forming a metallic layer comprises forming Hall effect plates or integrated magnetic concentrators.

6. The method of any one of claims 1 to 3 wherein providing the second component comprises providing a molding material.

7. The method of any one of the previous claims wherein providing an interlayer comprises providing a conformal interlayer.

8. The method of any one of the previous claims wherein providing the interlayer comprises providing alucone.

9. A sensor including a first component comprising a first material with a predetermined first value of coefficient of thermal expansion, a second material with a predetermined second value of coefficient of thermal expansion, and an interlayer comprising a third material between the first component and the second component, wherein the third material is an organic-inorganic hybrid polymer compound for minimizing stress caused by coefficient of thermal expansion mismatch between the first and second components.

10. The sensor of claim 9 wherein the conformal interlayer comprises alucone.

11. The sensor of any one of claims 9 or 10 wherein the first component comprises a lead frame and the second component comprises molding material.

12. The sensor of any one of claims 9 or 10 wherein the first component comprises a semiconductor substrate and the second component comprises molding material.

13. The sensor of any one of claims 9 or 10 wherein the first component comprises a semiconductor substrate and the second component comprises a metallic layer.

14. The sensor of claim 13 wherein the second component is a plate for Hall-effect sensing or an integrated magnetic concentrator.
